# EUROPÄISCHE PATENTSCHRIFT

(11) **EP 1 656 702 B1**
(45) Veröffentlichungstag und Bekanntmachung des Hinweises auf die Patenterteilung: **03.09.2008**
(21) Anmeldenummer: 04762682.5
(22) Anmeldetag: 16.08.2004
(51) Int. Cl.: H01L 29/786, H01L 21/336

(54) **VERFAHREN ZUR HERSTELLUNG EINES VERTIKALEN NANO-TRANSISTORS**
METHOD FOR PRODUCING VERTICAL NANO-TRANSISTOR
PROCEDE DE FABRICATION DE NANO-TRANSISTOR VERTICAL

(30) Priorität: 21.08.2003 DE 10339529
(43) Veröffentlichungstag der Anmeldung: 17.05.2006
(73) Patentinhaber: Helmholtz-Zentrum Berlin für Materialien und Energie GmbH, 14109 Berlin (DE)
(72) Erfinder: CHEN, Jie, 10589 Berlin (DE); KÖNENKAMP, Rolf, Portland, OR 97201 (US)
(74) Vertreter: Rudolph, Margit
(86) Internationale Anmeldenummer: PCT/DE2004/001839
(87) Internationale Veröffentlichungsnummer: WO 2005/022647

(56) Entgegenhaltungen:
- EP-A- 0 552 445
- DE-A- 10 142 913
- GB-A- 2 222 306
- US-A- 5 285 093

## Beschreibung

Die Erfindung betrifft ein Verfahren zur Herstellung eines vertikalen Nano-Transistors, aufweisend einen Source-Kontakt, einen Drain-Kontakt, einen Gate-Bereich und einen zylinderförmigen halbleitenden Kanalbereich zwischen dem Source- und dem Drain-Kontakt, wobei der Source-Kontakt, der halbleitende Kanalbereich und der Drain-Kontakt in vertikaler Richtung angeordnet sind und der Gate-Bereich durch eine Metallschicht gebildet ist, die koaxial zum halbleitenden Kanalbereich angeordnet ist.

In DE 101 42 913 A1 ist eine mechanischen Beanspruchungen durch Biegung, Scherung oder Dehnung gut widerstehende Transistoranordnung beschrieben, bei der in Mikrolöchern eines Folienverbundes, der aus zwei Kunststofffolien mit zwischenliegender Metallschicht besteht, vertikal Halbleitermaterial eingebracht ist. Das Halbleitermaterial ist mit metallischen Kontakten auf der Ober- und Unterseite des Folienverbundes versehen. Hierbei ist jedoch das Aufbringen einer Metallschicht auf eine Kunststofffolie nicht einfach handhabbar; außerdem umfasst das Verfahren zur Herstellung einer solchen vertikalen Transistoranordnung eine Vielzahl von einzelnen Verfahrensschritten. So wird zunächst ein Folienbund hergestellt, in dem mittels lonenbeschuss lonenspurkanäle erzeugt werden. Die zweite Folie wird mit der Metallschicht mittels eines Klebers verbunden, der jedoch bei den folgenden Verfahrensschritten die Verfahrenstemperatur begrenzt. In einer nachfolgenden Ätzbehandlung des Folienverbundes werden die lonenspurkanäle zu Mikrolöchem geätzt, auch die Metallschicht ist von dem Ätzprozess nicht ausgenommen, jedoch muss dieser Prozess sehr definiert ablaufen, um die Funktion des Gate-Bereiches zu realisieren.

Auch der in US 2002/0001905 beschriebene vertikale Nano-Transistor ist in seiner Herstellung aufwändig und kompliziert, da zunächst auf einem teuren Halbleiter-Substrat, das nicht flexibel ist, ein Source-Bereich und darauf eine isolierende Schicht aufgebracht wird. In der isolierenden Schicht (Al₂O₃ oder Si) sind Löcher im nm-Bereich angeordnet und in diesen Löchern sind vertikal ausgerichtete Kohlenstoff-Nanoröhren eingebracht. Der Gate-Bereich ist über der isolierenden Schicht um die Kohlenstoff-Nanoröhren angeordnet, dieser ist bis auf die obere Deckfläche der Nanoröhren ausgefüllt mit einem nichtleitenden Material. Das Ausbilden des Gate-Bereichs um die Nanoröhren und das Erhalten dieser Nanoröhren mit gleichen Durchmessern während des Auffüllens erweist sich als sehr schwierig. Dies kann zur Folge haben, dass vertikale Transistor-Anordnungen entstehen, die wegen der unterschiedlichen Durchmesser der jeweils zugehörigen Nanoröhre auch unterschiedliche Charakteristiken aufweisen.

Von Engelhardt und Könenkamp wurde in J. Appl. Phys., Vol. 90, No. 8, 15 October 2001, pp. 4287 - 4289, über die Möglichkeit berichtet, CuSCN mittels Elektrodeposition in mittels lonenbeschuss und anschließendem Ätzen in einer Polymerfolie hergestellte Löcher zu füllen. Die Löcher haben einen Durchmesser von 30 bis 3000 nm und sind nicht über die gesamte Dicke (22 µm) der Polymerfolie ausgebildet. Ein funktionsfähiges Bauelement mit einer derartigen Kanalstruktur wurde nicht beschrieben.

Bei dem in DE 101 30 766 A1 beschriebenen Vertikal-Transistor sind auf einem Halbleitersubstrat der Source-Bereich, der Kanalbereich und der Drain-Bereich in vertikaler Richtung angeordnet. Der zum Source-, Drain- und Kanalbereich isolierte Gate-Bereich umschließt den Kanalbereich und bildet eine koaxiale Struktur. Zwar konnte für die Herstellung dieser Anordnung der maschinelle und zeitliche Aufwand reduziert werden, jedoch kann diese Anordnung mechanischen Beanspruchungen wie Scherung, Biegung auch nur schlecht widerstehen.

Aufgabe der Erfindung ist es nun, ein Verfahren zur Herstellung eines vertikalen Nano-Transistors anzugeben, bei dem die Verfahrensschritte weniger aufwändig sind als bisher dem Stand der Technik nach bekannt und das die Erzeugung einer wohl definierten Gate-Struktur ermöglicht.

Das erfindungsgemäße Verfahren zur Herstellung eines vertikalen Nano-Transistors, aufweisend einen Source-Kontakt, einen Drain-Kontakt, einen Gate-Bereich und einen zylinderförmigen halbleitenden Kanalbereich zwischen dem Source- und dem Drain-Kontakt, wobei der Source-Kontakt, der halbleitende Kanalbereich und der Drain-Kontakt in vertikaler Richtung angeordnet sind und der Gate-Bereich durch eine Metallschicht gebildet ist, die koaxial zum halbleitenden Kanalbereich angeordnet ist, umfasst die Merkmale gemäß Anspruch 1. Danach werden zunächst Löcher in einem flexiblen isolierenden Substrat über dessen gesamte Dicke erzeugt, anschließend wird eine ein Gate bildende Metallschicht auf dem flexiblen isolierenden Substrat und im oberen Teil der durchgehenden Löcher aufgebracht, danach wird die entstandene Struktur mit einem Isolatormaterial versehen. Das Isolatormaterial befindet sich somit auf der mit der Metallschicht bedeckten oberen Fläche, der unteren Fläche des flexiblen Substrats und in den Löchern über die gesamte Dicke des flexiblen isolierenden Substrats. Anschließend wird auf der isolierten Unterseite des flexiblen Substrats ein Drain-Kontakt aufgebracht. Wie bereits erwähnt, ist die isolierende Schicht nicht notwendig für die Funktionsfähigkeit. Der Drain-Kontakt kann auch direkt auf die Unterseite des flexiblen isolierenden Substrats aufgebracht werden. In die Löcher des flexiblen Substrats wird Halbleitermaterial eingefüllt und der entstandene halbleitende Kanalbereich wird abschließend mit einem Source-Kontakt versehen.

In Ausführungsformen der Erfindung ist vorgesehen, dass die Löcher in dem flexiblen Substrat mittels lonenbeschuss und anschließendem Ätzen (s. beispielsweise 3rd Siberian Russian Workshop and Tutorials EDM'2002, Section 1, 1-5 July, Erlagol, pp. 31 oder - bereits erwähnt - J. Appl. Phys., Vol. 90, No. 8, 15 October 2001, pp. 4287 - 4289) erzeugt werden.

Es wird ein flexibles isolierendes Substrat mit einer Dicke von einigen Zehn Mikrometern, beispielsweise eine Polymerfolie, verwendet.

Für die Isolatorschicht wird organisches oder anorganisches Material verwendet. Das organische Material kann mittels Polystiring aufgebracht werden.

In einer Ausführungsform der Erfindung ist vorgesehen, dass die das Gate bildende Metallschicht durch Aufdampfen, vorzugsweise von oben unter einem Winkel, aufgebracht wird.

Das halbleitende Material wird durch elektrochemische Badabscheidung oder durch chemische Deposition oder mittels ILGAR-Verfahren in die isolierten Löcher eingebracht. Als Material hierfür wird CuSCN oder TiO₂ oder PbS oder ZnO oder ein anderer Verbindungshalbleiter verwendet.

Es ist vorgesehen, als Material für den Drain- und den Source-Kontakt Ag oder Au oder Ni oder Al zu verwenden.

Das Aufbringen des Drain-Kontaktes erfolgt mittels Elektrodeposition oder chemischer Deposition oder Aufdampfen.

Das Herstellungsverfahren für eine vertikale Nano-Transistor-Anordnung, bei dem nun nicht mehr von einem aufwändig herzustellenden Folienverbund aus zwei Polymerfolien mit zwischenliegender Metallschicht ausgegangen werden muss, ist einfach handhabbar und passt sich in die bekannten Dünnfilmtechologien ein. Ein die Technologietemperatur begrenzender Kleber ist bei dem erfindungsgemäßen Herstellungsverfahren nicht mehr notwendig.

Mittels des erfindungsgemäßen Verfahrens ist ein vertikaler Nano-Transistor herstellbar, bei dem der zylinderförmige Kanalbereich in ein flexibles isolierendes Substrat eingebettet und vom Gate-Bereich, der von einer Metallschicht auf dem flexiblen isolierenden Substrat und im oberen Teil des Kanalbereichs gebildet ist, derart umschlossen ist, dass der Gate-Bereich und der obere Abschnitt des Kanalbereichs eine koaxiale Struktur bilden und der Gate-Bereich zum Source-Kontakt, zum Drain-Kontakt und zum halbleitenden Kanalbereich und die Ober- und Unterseite des flexiblen Substrats eine elektrische Isolierung aufweist.

Das erfindungsgemäße Verfahren benötigt keine Nano-Lithographie-Schritte und liefert eine mechanischen Beanspruchungen widerstehende robuste Struktur eines vertikalen Nano-Tansistors. Dies ist möglich durch die Einbettung der Nano-Struktur in ein flexibles Substrat. Es entfällt hierbei das schwierige Aufbringen einer großflächigen Metallschicht auf eine Kunststofffolie; außerdem müssen nicht einzelne Folien wie in der erwähnten Lösung DE 101 42 913 A1 zu einem Folienverbund zusammengefügt werden.

Mit dem erfindungsgemäßen Verfahren ist auch eine Speicheranordnung herstellbar, die in einem flexiblen Substrat eine Vielzahl nebeneinander angeordneter vertikaler Nano-Transistoren aufweist.

Die Erfindung soll in folgendem Ausführungsbeispiel anhand von Zeichnungen näher erläutert werden.

Dabei zeigen:
- Fig. 1: Herstellungsschritte erfindungsgemäßer vertikaler Nano-Transistoren, die in eine flexible isolierende Polymerfolie eingebettet sind;
- Fig. 2: Strom-Spannungs-Kennlinien für eine Anordnung mit ca. 2000 erfindungsgemäßen vertikalen Nano-Transistoren.

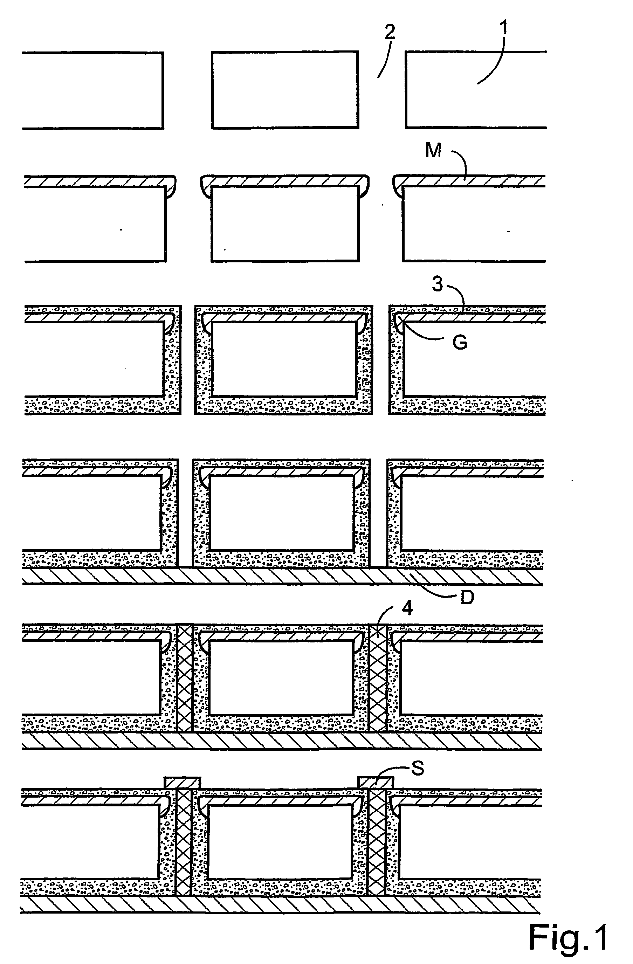

In Figur 1 sind die einzelnen Verfahrensschritte zur Herstellung erfindungsgemäßer vertikaler Nano-Transistoren dargestellt. Zunächst werden in einem flexiblen isolierenden Substrat **1,** beispielsweise eine 20 µm dicke Polymerfolie, Löcher **2** durch lonenbeschuss und anschließendem Ätzen mit einem Durchmesser von 200 nm erzeugt. Anschließend wird die das Gate **G** bildende Metallschicht **M,** beispielsweise Au, mittels Schrägaufdampfung auf die Oberseite des flexiblen isolierenden Substrats **1** und im oberen Bereich der Löcher **2** auf deren Wandung aufgebracht. Danach wird ein organisches isolierendes Material, beispielsweise Polystyrene, durch Vakuumfiltration einer Polymerlösung so aufgebracht, dass es die Wandung der Löcher **2** und die Ober- und Unterseite des flexiblen Substrats **1** mit einer Isolationsschicht **3** bedeckt. Die Dicke dieser Schicht **3** beträgt auf der Wand der Löcher **2** 50 nm. Anschließend wird auf die Unterseite der mit einer 2,5 µm-dicken isolierenden Schicht **3** versehenen Polymerfolie **1** der Drain-Kontakt **D** flächig abgeschieden. Danach werden die isolierten Löcher **2** in der Polymerfolie **1** mit CuSCN verfüllt. Damit ist die Bildung eines halbleitenden Kanalbereiches **4** mit einem Durchmesser von 100 nm abgeschlossen. Abschließend wird jeder Kanalbereich **4** mit einem punktförmigen Söurce-Kontakt **S** abgedeckt.

Die erfindungsgemäße Lösung ermöglicht eine Dichte von vertikalen Nano-Transistoren in der flexiblen Polymerfolie derzeit bis etwa 10⁷ cm⁻².

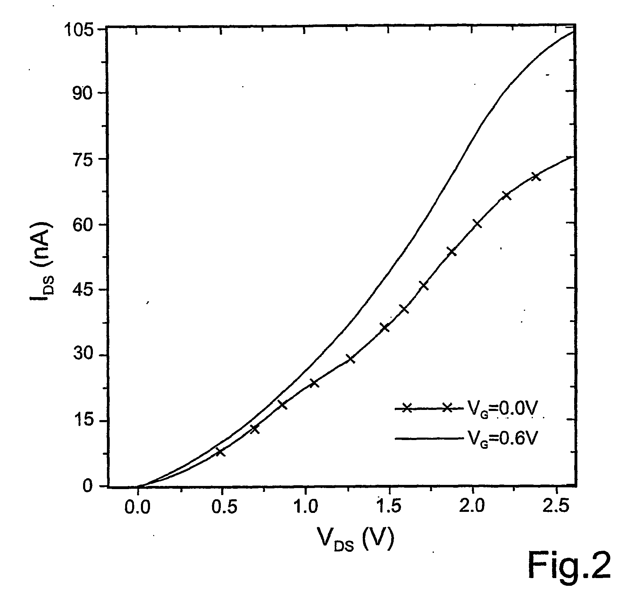

Die Figur 2 zeigt Strom-Spannungs-Kennlinien (Abhängigkeit des Stromes I_{DS} - dem Strom im Kanal zwischen Drain- und Source-Kontakt - von der zwischen Drain- und Source-Kontakt gemessenen Spannung V_{DS} sowohl ohne als auch mit negativer Spannung am Gate), die den Feld-Effekt erkennen lassen, einer Anordnung mit ca. 2000 nach dem erfindungsgemäßen Verfahren hergestellten vertikalen Nano-Transistoren, die in einem Polymersubstrat einer Dicke von 8 µm ausgebildet waren. Die auf dem Substrat aufgebrachte und das Gate bildende Metallschicht hatte eine Dicke von 110 nm, der Durchmesser des halbleitenden Kanals betrug 100 nm.

## Patentansprüche

1. Verfahren zur Herstellung vertikaler Nano-Transistoren,
umfassend mindestens die Verfahrensschritte
- Erzeugen von Löchern (2) in einem flexiblen isolierenden Substrat (1) über dessen gesamte Dicke,
- Aufbringen einer ein vertikales Gate (G) bildenden Metallschicht (M) auf dem flexiblen isolierenden Substrat (1) und im oberen Teil der durchgehenden Löcher (2),
- Aufbringen eines Isolatormaterials (3) auf der mit der Metallschicht (M) bedeckten oberen Fläche, der unteren Fläche des flexiblen isolierenden Substrats (1) und der Löcher (2) über die gesamte Dicke des flexiblen isolierenden Substrats (1),
- Aufbringen eines Drain-Kontakts (D) auf der unteren mit dem Isolatormaterial (3) versehenen Fläche des flexiblen isolierenden Subtrats (1),
- Einfüllen eines Halbleitermaterials in die durchgehenden Löcher (2) des flexiblen isolierenden Substrats (1) und
- Aufbringen eines Source-Kontakts (S) auf die mit dem Halbleitermaterial ausgefüllten Löcher (2).

2. Verfahren nach Anspruch 1,
bei dem die Löcher (2) in dem flexiblen isolierenden Substrat (1) mittels lonenbeschuss und anschließendem Ätzen erzeugt werden.

3. Verfahren nach Anspruch 1,
bei dem ein flexibles isolierendes Substrat (1) mit einer Dicke von einigen Zehn Mikrometern verwendet wird.

4. Verfahren nach Anspruch 1,
bei dem als flexibles isolierendes Substrat (1) eine Polymerfolie verwendet wird.

5. Verfahren nach Anspruch 1,
bei dem das Isolatormaterial (3) mittels Polystiring aufgebracht wird.

6. Verfahren nach Anspruch 1,
bei dem das Gatematerial durch Aufdampfen eingebracht wird.

7. Verfahren nach Anspruch 6,
bei dem das Aufdampfen des Gate-Materials von oben unter einem Winkel erfolgt.

8. Verfahren nach Anspruch 1,
bei dem das Aufbringen des Drain-Kontaktes (D) mittels Elektrodeposition oder chemischer Deposition oder Aufdampfen erfolgt.

9. Verfahren nach Anspruch 1,
bei dem als Material für den Drain-(D) und den Source-Kontakt (S) Au oder Ag oder Cu oder Ni oder Al verwendet wird.

10. Verfahren nach Anspruch 1,
bei dem als Halbleitermaterial CuSCN oder TiO₂ oder PbS oder ZnO oder ein anderer Verbindungshalbleiter verwendet wird.

11. Verfahren nach Anspruch 1,
bei dem das Halbleitermaterial durch elektrochemische Badabscheidung in die isolierten Löcher (2) eingebracht wird.

12. Verfahren nach Anspruch 1,
bei dem das Halbleitermaterial durch chemische Deposition in die isolierten Löcher (2) eingebracht wird.

13. Verfahren nach Anspruch 1,
bei dem das Halbleitermaterial mittels ILGAR-Verfahren in die isolierten Löcher (2) eingebracht wird.

14. Verfahren nach Anspruch 1,
bei dem die durchgehenden Löcher (2) in dem flexiblen isolierenden Substrat (1) mit einem Durchmesser von einigen Zehn bis zu einigen Hundert Nanometern erzeugt werden.

15. Verfahren nach Anspruch 1,
bei dem das Isolatormaterial (3) auf der oberen Fläche des flexiblen isolierenden Substrats (1) in einer Dicke von einigen Mikrometern aufgebracht wird.

16. Verfahren nach Anspruch 1,
bei dem das Isolatormaterial (3) in den durchgehenden Löchern (2) im flexiblen isolierenden Substrat (1) in einer Dicke bis zu einigen Zehn Nanometern aufgebracht wird.

## Claims

1. Method for producing vertical nano-transistors, comprising at least the method steps
- creation of holes (2) in a flexible insulating substrate (1), over the entire thickness of the latter,
- application of a metal layer (M), forming a vertical gate (G), to the flexible insulating substrate (1) and in the upper portion of the through holes (2),
- application of an insulator material (3) to the upper surface covered with the metal layer (M), to the lower surface of the flexible insulating substrate (1) and to the holes (2), over the entire thickness of the flexible insulating substrate (1),
- application of a drain contact (D) to the lower surface of the flexible insulating substrate (1) that is provided with the insulator material (3),
- filling of a semiconductor material into the through holes (2) of the flexible insulating substrate (1), and
- application of a source contact (S) to the holes (2) filled with the semiconductor material.

2. Method according to Claim 1,
wherein the holes (2) in the flexible insulating substrate (1) are created by means of ion bombardment and subsequent etching.

3. Method according to Claim 1,
wherein a flexible insulating substrate (1) having a thickness of some ten micrometres is used.

4. Method according to Claim 1,
wherein a polymer film is used as a flexible insulating substrate (1).

5. Method according to Claim 1,
wherein the insulator material (3) is applied by vacuum filtration of a polymer solution.

6. Method according to Claim 1,
wherein the gate material is put in place by vapour deposition.

7. Method according to Claim 6,
wherein the vapour deposition of the gate material is effected from above, at an angle.

8. Method according to Claim 1,
wherein the application of the drain contact (D) is effected by means of electrodeposition or chemical deposition or vapour deposition.

9. Method according to Claim 1,
wherein Au or Ag or Cu or Ni or Al is used as material for the drain contact (D) and for the source contact (S).

10. Method according to Claim 1,
wherein CuSCN or TiO₂ or PbS or ZnO or another compound semiconductor is used as semiconductor material.

11. Method according to Claim 1,
wherein the semiconductor material is placed in the insulated holes (2) by electrochemical bath deposition.

12. Method according to Claim 1,
wherein the semiconductor material is placed in the insulated holes (2) by chemical deposition.

13. Method according to Claim 1,
wherein the semiconductor material is placed in the insulated holes (2) by means of ILGAR methods.

14. Method according to Claim 1,
wherein the through holes (2) in the flexible insulating substrate (1) are created with a diameter of some ten to some hundred nanometres.

15. Method according to Claim 1,
wherein the insulator material (3) is applied to the upper surface of the flexible insulating substrate (1) to a thickness of some micrometres.

16. Method according to Claim 1,
wherein the insulator material (3) in the through holes (2) in the flexible insulating substrate (1) is applied to a thickness of up to some ten nanometres.

## Revendications

1. Procédé d'obtention de nano-transistors verticaux comportant au moins les étapes suivantes :
- formation de trous (2) dans un substrat isolant flexible (1) sur la totalité de l'épaisseur de ce substrat,
- application d'une couche métallique (M) formant une grille verticale (G) sur le substrat isolant flexible (1) et dans la partie supérieure des trous traversants (2),
- application d'un matériau non-conducteur (3) sur la surface supérieure recouverte par la couche métallique (M), sur la couche inférieure du substrat isolant flexible (1) et les trous (2), sur la totalité de l'épaisseur du substrat isolant flexible (1),
- application d'un contact de drain (D) sur la surface inférieure du substrat isolant flexible (1) pourvue du matériau non-conducteur (3),
- remplissage des trous traversants (2) du substrat isolant flexible (1) par un matériau semi-conducteur, et
- application d'un contact de source (S) sur les trous (2) remplis du matériau semi-conducteur.

2. Procédé selon la revendication 1,
selon lequel on forme les trous (2) dans le substrat isolant flexible (1) par bombardement ionique puis décapage.

3. Procédé selon la revendication 1,
selon lequel on utilise un substrat isolant flexible (1) ayant une épaisseur de quelques dizaines de micromètres.

4. Procédé selon la revendication 1,
selon lequel en tant que substrat isolant flexible (1), on utilise une feuille de polymère.

5. Procédé selon la revendication 1,
selon lequel on applique le matériau non-conducteur (3) par filtration sous vide d'une solution polymère.

6. Procédé selon la revendication 1,
selon lequel on applique le matériau de grille par vaporisation.

7. Procédé selon la revendication 6,
selon lequel on vaporise le matériau de grille par le haut et sous un angle.

8. Procédé selon la revendication 1,
selon lequel on applique le contact de drain (D) par électrodéposition ou déposition chimique ou vaporisation.

9. Procédé selon la revendication 1,
selon lequel en tant que matériau pour le contact de drain (D) et le contact de source (S), on utilise Au ou Ag ou Cu ou Ni ou Al.

10. Procédé selon la revendication 1,
selon lequel en tant que matériau semi-conducteur, on utilise CuSCN ou TiO₂ ou PbS ou ZnO ou une autre composition semi-conductrice.

11. Procédé selon la revendication 1,
selon lequel on introduit le matériau semi-conducteur dans les trous isolés (2) par déposition en bain électrochimique.

12. Procédé selon la revendication 1,
selon lequel on introduit le matériau semi-conducteur dans les trous isolés (2) par déposition chimique.

13. Procédé selon la revendication 1,
selon lequel on introduit le matériau semi-conducteur dans les trous isolés (2) par le procédé ILGAR.

14. Procédé selon la revendication 1,
selon lequel on forme dans le substrat isolant flexible (1) des trous traversants (2) ayant un diamètre de quelques dizaines à quelques centaines de nanomètres.

15. Procédé selon la revendication 1,
selon lequel on applique le matériau non-conducteur (3) sur la surface supérieure du substrat isolant flexible (1) sur une épaisseur de quelques micromètres.

16. Procédé selon la revendication 1,
selon lequel on applique le matériau non conducteur (3) dans les trous traversants (2), dans le substrat isolant flexible (1) sur une épaisseur allant jusqu'à quelques dizaines de manomètres.
